# EUROPEAN PATENT SPECIFICATION

(11) **EP 2 441 861 B1**
(45) Date of publication and mention of the grant of the patent: **11.03.2020**
(21) Application number: 10786007.4
(22) Date of filing: 23.04.2010
(51) Int. Cl.: C30B 23/00, C30B 29/36

(54) **DEVICE FOR PRODUCING SILICON CARBIDE SINGLE CRYSTALS**
VORRICHTUNG ZUR HERSTELLUNG VON SILICIUMCARBID-EINZELKRISTALLEN
DISPOSITIF PERMETTANT LA PRODUCTION DE MONOCRISTAUX DE CARBURE DE SILICIUM

(30) Priority: 10.06.2009 JP 2009139253
(43) Date of publication of application: 18.04.2012
(73) Proprietor: Showa Denko K.K., Tokyo 105-8518 (JP)
(72) Inventor: KONDO, Daisuke, Kodaira-shi Tokyo 187-8531 (JP)
(74) Representative: Lamb, Martin John Carstairs
(86) International application number: PCT/JP2010/057218
(87) International publication number: WO 2010/143476

(56) References cited:
- EP-A1- 1 354 987
- EP-A2- 1 464 735
- WO-A1-01/63020
- WO-A1-99/29934
- WO-A1-2009/060561
- WO-A1-2009/060561
- WO-A2-2008/089181
- WO-A2-2008/089181
- JP-A- H11 278 985
- JP-A- 2005 225 710
- JP-A- 2005 225 710
- JP-A- 2009 091 173
- US-A- 5 968 261

## Description

### TECHNICAL FIELD

The present invention relates to an apparatus of manufacturing a silicon carbide single crystal, and in particular, relates to an apparatus of manufacturing a silicon carbide single crystal capable of manufacturing a good single crystal in which a recessed surface is not generated at a radial direction end.

### BACKGROUND ART

Conventionally, a sublimation recrystallization method is known as a method of manufacturing a silicon carbide single crystal by which a silicon carbide single crystal (hereinafter, briefly abbreviated as a single crystal) is produced from a seed crystal including a silicon carbide and a sublimation material. In the sublimation recrystallization method, the sublimation material is heated and sublimed to generate a sublimed gas, and the sublimed gas is supplied to the seed crystal, as a result of which a single crystal of silicon carbide is grown from the seed crystal.

In this case, there is disclosed a technology in which in order that the sublimed gas is concentrated and effectively supplied to the seed crystal, a cone-shaped guide of which the diameter gradually increases as it goes downward is used (for example, see Patent Documents 1 and 2). Also, there is known a conically-shaped (tapered) manufacturing apparatus of which the diameter of the upper inner wall surface of a crucible main body gradually increases as it goes downward (for example, see Patent Document 3).

### PRIOR ART DOCUMENT

### PATENT DOCUMENT

Patent Document 1: JP-A-2002-60297
Patent Document 2: JP-A-2004-224663
Patent Document 3: JP-A-2007-308355
Patent Document 4: WO 2008/089181
Patent Document 5: JP 2005 225710
Patent Document 6: WO 2009/060561
Patent Document 7: WO 01/63020
Patent Document 8: US 5 968 261
Patent Document 9: WO 99/29934
Patent Document 10: JP 2009 091173
Patent Document 11: EP 1354987
Patent Document 12: JP H11 278985

Patent documents 4 to 12 disclose manufacturing devices for crystals.

### SUMMARY OF THE INVENTION

However, if the single crystal is produced by using the above-described conventional apparatuses for manufacturing a silicon carbide single crystal, then a quality defect that the lower surface of the radial direction end is dented in recess may be found. This may probably result from the fact that in the technologies according to Patent Documents 1 and 2, the heat traveling from the sublimation material to the seed crystal flows from a guide member to outside the guide member as the crystal growth is progressed. Further, in the technology according to Patent Document 3, it may be possible that the upper inner wall surface of the crucible main body is made of graphite with a high heat conductivity, and thus, as the crystal growth is progressed, the heat traveling from the sublimation material to the seed crystal flows from the upper inner wall surface to the crucible main body.

Therefore, the present invention was intended to overcome the above-described circumstance, and an object thereof is to provide an apparatus of manufacturing a silicon carbide single crystal by which it is possible to produce a high-quality silicon carbide single crystal in which a recessed surface is not formed at the radial direction end of a grown crystal.

The present invention is set out in claim 1.

Thus, a heat insulating material is arranged at the outer peripheral side of a seed crystal supporting member, and therefore, it is possible to concentrate a heat flow traveling from a sublimation material to a seed crystal onto the seed crystal by the heat insulating material. Therefore, the recessed surface is not formed at the radial direction end of the grown single crystal, and thus, it is possible to produce a high-quality single crystal.

According to the apparatus of manufacturing the silicon carbide single crystal of the present invention, it is possible to produce a high-quality single crystal without the formation of a recessed surface at the radial direction end of a grown single crystal.

### BRIEF DESCRIPTION OF THE DRAWINGS

[Fig. 1] Fig. 1 is an explanatory diagram of an apparatus of manufacturing a silicon carbide single crystal not according to the present invention.
[Fig. 2] Fig. 2 is a cross-sectional view of the apparatus of manufacturing a silicon carbide single crystal according to the present invention.
[Fig. 3] Fig. 3 is a cross-sectional view showing a modification of the apparatus of manufacturing a silicon carbide single crystal according to the present invention.
[Fig. 4] Fig. 4 is a cross-sectional view showing a first reference embodiment of an apparatus of manufacturing a silicon carbide single crystal which is not according to the present invention.
[Fig. 5] Fig. 5 is a schematic diagram showing a flow of heat in the vicinity of a single crystal which is not according to the present invention but useful for understanding it; Fig. 5(a) shows a growth initial stage of the single crystal; and Fig. 5(b) shows a certain growth stage of the single crystal.
[Fig. 6] Fig. 6 is a cross-sectional view showing an apparatus of manufacturing a silicon carbide single crystal according to a comparative example.
[Fig. 7] Fig. 7 is a schematic diagram showing a flow of heat in the vicinity of a single crystal according to the comparative example; Fig. 7(a) shows a growth initial stage of the single crystal; and Fig. 7(b) shows a certain growth stage of the single crystal.
[Fig. 8] Fig. 8 is a cross-sectional view showing an apparatus of manufacturing a silicon carbide single crystal according to a second reference embodiment of the present invention.
[Fig. 9] Fig. 9 is a cross-sectional view showing an apparatus of manufacturing a silicon carbide single crystal according to a third reference embodiment of the present invention.

### BEST MODES FOR CARRYING OUT THE INVENTION

Hereinafter, details of an apparatus of manufacturing a silicon carbide single crystal according to embodiments of the present invention will be described with reference to the accompanying drawings. It will be appreciated that the drawings are schematically shown and a thickness and a ratio of the thickness of each material layer are different from a real size. Therefore, detailed thickness and dimension should be determined considering the following description. Of course, among the drawings, the dimensional relationship and the ratio may be different.

### [First Embodiment]

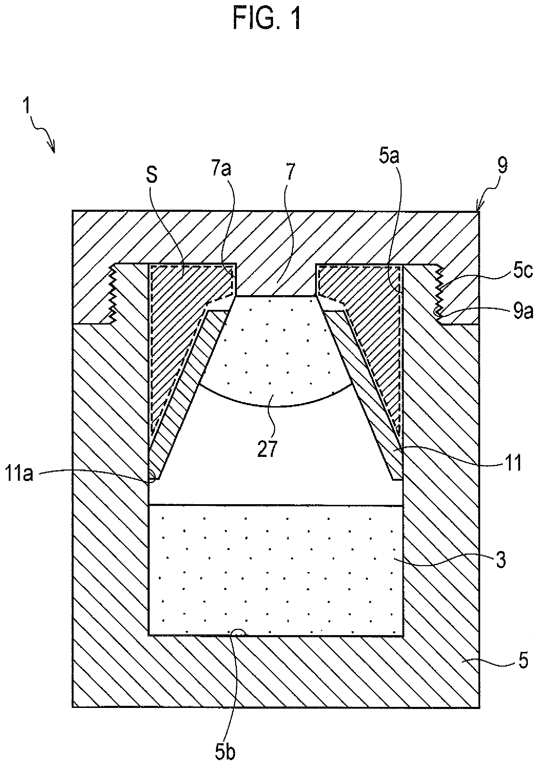

Firstly, a first embodiment of the present invention will be described. Fig. 1 is an explanatory diagram of an apparatus of manufacturing a silicon carbide single crystal not according to the present invention.

The manufacturing apparatus 1 includes: a crucible main body 5 of which one side (in this embodiment, an upper portion. Hereinafter, one side means the upper portion) is opened and which internally houses a sublimation material 3; a lid member 9 which is arranged to seal the opened upper portion of the crucible man body 5 and which includes a seed crystal supporting member 7 configured to fix a seed crystal at a position facing the sublimation material 3; a guide member 11 that extends in a cylindrical shape toward the sublimation material 3, i.e., the other side (in this embodiment, a lower side. Hereinafter, the other side, which is the opposite side of one side, means the lower side) at the opposite side of the one side from the vicinity the outer periphery of a single crystal supporting member 7; and a heat insulating material arranged at an outer peripheral side of at least one of the seed crystal supporting member 7 and the guide member 11. This results in a configuration such that when the sublimation material 3 and the seed crystal are heated to grow a single crystal, a flow of heat traveling from the sublimation material 3 to the seed crystal is concentrated onto the seed crystal by the heat insulating material.

The crucible main body 5 is formed in a cylindrical form of which the upper end is opened, and at a bottom 5b, the powdered sublimation material 3 made from silicon carbide is housed. A screw 5c is formed at the outer peripheral side of the upper end, and the lid member 9 is configured to be screwed into the screw 5c. The crucible main boy 5 is made of graphite.

The lid member 9 also is formed in a cylindrical shape, and on the inner peripheral surface of a sidewall portion, a screw 9a that is screwed into the upper end of the crucible main body 5 is formed. In the lid member 9, at the center in a radial direction of an inner surface at a position facing the sublimation material, a cylindrical seed crystal supporting member 7 configured to fix a seed crystal is protruded toward an inner side (i.e., a lower side that is a side of the sublimation material) of the crucible main body 5. The lid member 9 also is made of graphite.

The guide member 11 is formed such that it expands in a circular truncated cone shape downwardly from the vicinity of an outer peripheral side of the seed crystal supporting member 7. The lower end portion 11a of the guide member 11 is locked with an inner wall surface 5a of the crucible main body 5, so that the guide member 11 is held.

Then, in a state where the lid member 9 is screwed into the upper end of the crucible main body 5, a predetermined space S illustrated by hatching in Fig. 1 is defined by the outer peripheral surface 7a of the seed crystal supporting member 7, the outer peripheral surface of the guide member 11, the inner wall surface 5a of the upper end of the crucible main body 5, and the inner surface of the lid member 9. The predetermined space S is formed in an approximately cylindrical shape. In this embodiment, at any region in the predetermined space S, i.e., at the outer peripheral side of at least one of the seed crystal supporting member 7 and the guide member 11, a heat insulating material is arranged. Examples of a material of the heat insulating material preferably include carbon felt.

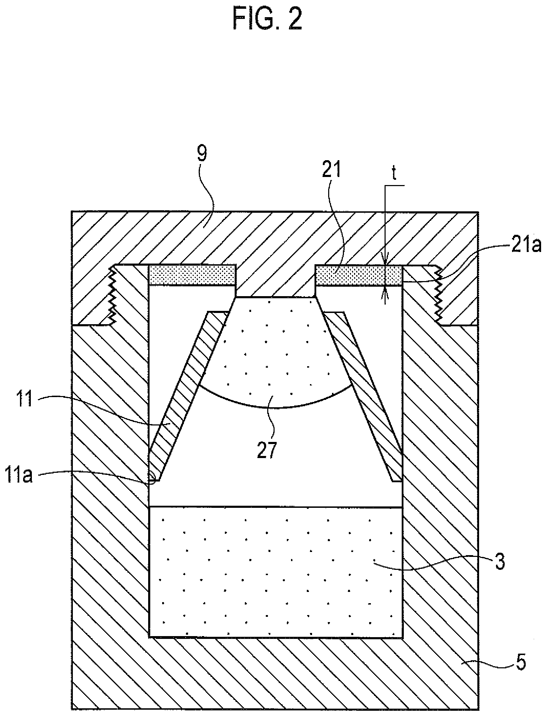

Fig. 2 is a cross-sectional view of the apparatus of manufacturing a silicon carbide single crystal according to the present invention.

The above-described heat insulating material 21 is in a disk shape and is attached to the inner surface of the lid member 9. The inner peripheral surface of the heat insulating material 21 contacts with the outer peripheral surface 7a of the seed crystal supporting member 7, and the outer peripheral surface 21a of the heat insulating material 21 contacts with the inner peripheral surface of the lid member 9. The thickness t of the heat insulating material 21 is formed to be thinner than the height of the seed crystal supporting member 7, and examples of attaching means include adhesion by an adhesive.

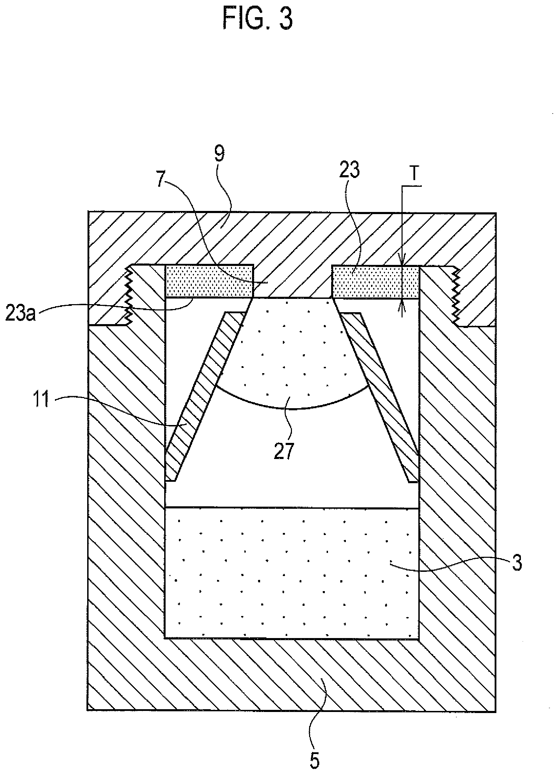

Fig. 3 is a cross-sectional view showing a modification of the apparatus of manufacturing a silicon carbide single crystal according to the present invention.

The heat insulating material 23 is approximately the same as that in Fig. 2, and the thickness thereof is approximately the same as the height of the seed crystal supporting member 7. Therefore, in a state where the heat insulating material 23 is attached to the lid member 9, a lower surface 23a of the heat insulating material 23 and a lower surface of the seed crystal supporting member 7 are formed on the approximately same plane.

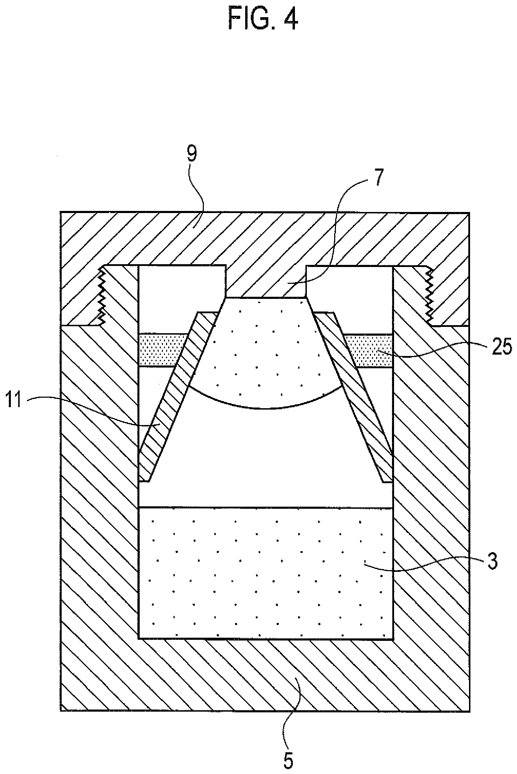

Fig. 4 is a cross-sectional view showing a first reference embodiment of an apparatus of manufacturing a silicon carbide single crystal which is based on the first embodiment of the present invention, but not according to the present invention.

This heat insulating material 25 also is formed in a disk shape, and its height position is arranged above the guide member 11. That is, the heat insulating material 25 expands in a lateral direction from the outer peripheral surface above the guide member 11 to extend to the inner wall surface 5a of the crucible main body 5.

Subsequently, a heat flow in the vicinity of the guide member in the manufacturing apparatus according to the embodiment is briefly described.

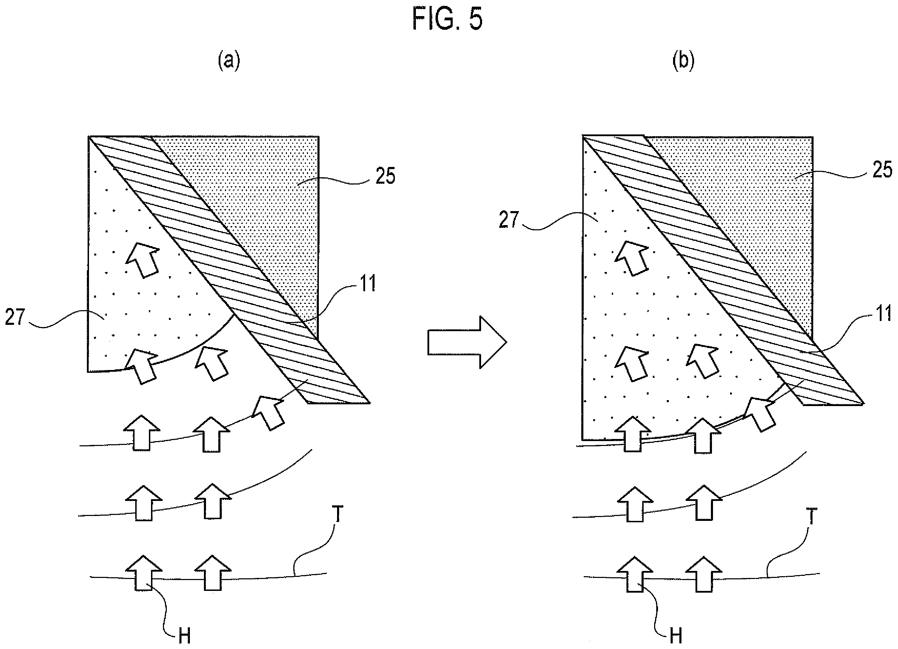

Fig. 5 is a schematic diagram showing the heat flow in the vicinity of the single crystal, not according to the present invention but useful for understanding it, being based on the first embodiment of the present invention; Fig. 5(a) illustrates a growth initial stage of the single crystal; and Fig. 5(b) illustrates a certain growth stage of the single crystal.

At a high temperature region exceeding 2000°C, when comparison is made among a space, graphite (carbon), silicon carbon (SiC), and a heat insulating material in terms of heat conductivity, the order is space to graphite (carbon) to silicon carbide (SiC) to heat insulating material.

In Figs. 5(a) and (b), the heat flow is illustrated by an arrow where T denotes an isothermal line linking regions with the same temperature in the vicinity of the single crystal. The arrow is perpendicular to the isothermal line T, and therefore, the direction of the flow of heat H is in a direction perpendicular to the isothermal line T. At the outer peripheral side of the guide member 11, the heat insulating material 25 is arranged.

As illustrated in Fig. 5(a), when the sublimation material 3 and the seed crystal are heated, the heat H moves upwardly from the sublimation material 3. In the heat temperature, the sublimation material 3 is set higher than the seed crystal. At the outer peripheral side of the guide member 11, the heat insulating material 25 is arranged, and the heat conductivity of the heat insulating material 25 is lower than that of the silicon carbide configuring the seed crystal, and thus, when the heat H moves to the vicinity of the guide member 11, a movement direction changes along the inner peripheral side of the guide member 11, and the heat H is concentrated onto the SiC single crystal, as a result of which the isothermal line T is formed in a protruding shape below. Therefore, as illustrated in Fig. 5(b), the single crystal 27 grows in a protruding shape below along the isothermal line T, and thus, the recessed surface is not formed at the radial direction end as in the conventional technology.

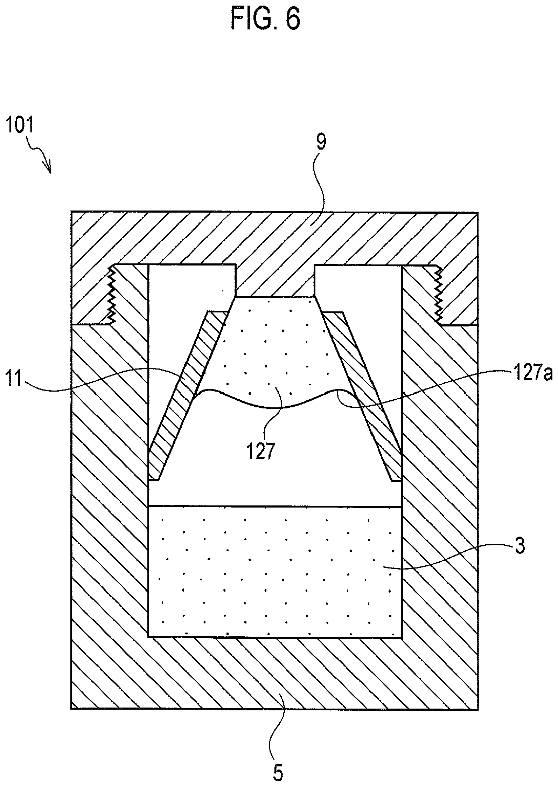

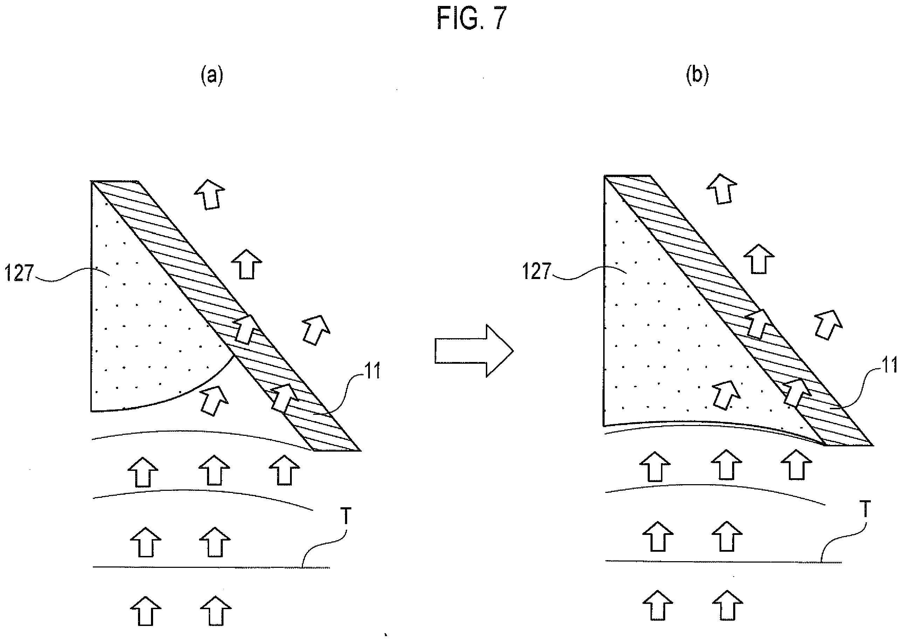

On the other hand, a manufacturing apparatus 101 according to the conventional technology does not include the heat insulating material, as illustrated in Fig. 6, and thus, a radial direction end 127a of a single crystal 127 surrounded by a circle is formed on a recessed surface. This is described with reference to Fig. 7.

As illustrated in Fig. 7(a), when the sublimation material 3 and the seed crystal are heated, heat H moves upwardly from the sublimation material 3. In the heat temperature, the sublimation material 3 is set higher than the seed crystal. The heat conductivity of the space S is higher than that of the SiC single crystal 127, and thus, when the heat H moves to the vicinity of the guide member 11, the heat H passes through the guide member 11 and moves through to the outer peripheral side of the guide member 11. Therefore, the heat H is not concentrated toward the SiC single crystal 127, and thus, the shape of the isothermal line T is formed into an upwardly protruding curved shape and the recessed surface is formed in the radial direction end 127a of the single crystal 27.

The advantage and effect according to the embodiment will be described.
(1) The apparatus 1 for manufacturing a single crystal according to the first embodiment of the present invention includes: a crucible main body 5 that houses the sublimation material 3; a lid member 9 in which a seed crystal supporting member 7 configured to fix a seed crystal is arranged at a position facing the sublimation material 3; a guide member 11 that extends in a cylindrical shape toward the sublimation material 3 from the vicinity of the outer periphery of the seed crystal supporting member 7; and heat insulating materials 21, 23 according to the invention, and 25 not according to the invention arranged at an outer peripheral side of at least one of the seed crystal supporting member 7 and the guide member 11. This results in a configuration such that when the sublimation material 3 and the seed crystal are heated to grow a single crystal 27, a flow of heat H traveling from the sublimation material 3 to the seed crystal is concentrated onto the seed crystal by the heat insulating materials 21, 23, and 25.

Thus, the heat insulating materials 21, 23, and 25 are arranged at the outer peripheral side of at least one of the seed crystal supporting member 7 and the guide member 11, and thus, it is possible to concentrate the flow of the heat H traveling from the sublimation material 3 to the seed crystal onto the seed crystal by the heat insulating materials 21, 23, and 25. Therefore, it is possible to produce the single crystal 27 having a high quality, without a chance that the recessed surface is formed at the radial direction end of the grown single crystal 27.

### [Second Reference Embodiment]

Subsequently, a second reference embodiment not according to the present invention is described; however, the parts having the same structure as those in the above-described invention are assigned with the same numeral so as to omit the description.

In this embodiment, the guide member itself is made of a heat insulating material.

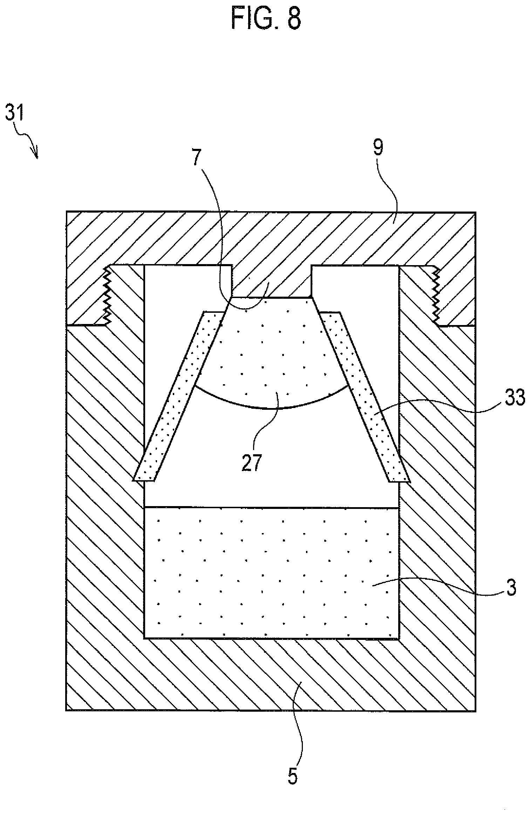

Fig. 8 is a cross-sectional view showing an apparatus of manufacturing a silicon carbide single crystal according to the reference embodiment not according to the present invention.

The manufacturing apparatus 31 according to this embodiment is formed by: the crucible main body 5 of which the upper portion is opened and which internally houses the sublimation material 3; a lid member 9 which is arranged to seal the opened upper portion of the crucible main body 5 and in which a seed crystal supporting member 7 is arranged at the internal side of the crucible main body 5; and a guide member 33 that extends in a cylindrical shape toward the sublimation material 3, i.e., downwardly, from the vicinity of the outer periphery of the seed crystal supporting member 7. In the apparatus, the guide member 33 is made of a heat insulating material. This results in a configuration such that when the sublimation material 3 and the seed crystal are heated to grow a single crystal, a flow of heat H traveling from the sublimation material 3 to the seed crystal is concentrated onto the seed crystal by the guide member 33.

The shape of the guide member 33, which is formed identically to the invention, is formed such that it expands in a circular truncated cone shape downwardly from the vicinity of the outer peripheral side of the seed crystal supporting member 7. The lower end 33a of the guide member 33 is locked with an inner wall surface 5a of the crucible main body 5, so that the guide member 33 is held. The material of the guide member 33 itself is made of a heat insulating material.

The effect according to the second reference embodiment will be described.
(1) The apparatus 31 for manufacturing a silicon carbide single crystal according to this embodiment include: a crucible main body 5 that stores a sublimation material 3; a lid member 9 including a seed crystal supporting member 7 configured to fix a seed crystal at a position facing the sublimation material 3; and a guide member 33 of cylindrical shape extending from the vicinity of the outer periphery of the seed crystal supporting member 7 toward the sublimation material 3, in which as a result of the guide member 33 being made of a heat insulating material, when the sublimation material 3 and the seed crystal are heated to grow a single crystal 27, a flow of heat H traveling from the sublimation material 3 to the seed crystal is concentrated onto the seed crystal by the guide member 33 made of a heat insulating material.

According also to this second embodiment, it is possible to concentrate the flow of the heat H traveling from the sublimation material 3 to the seed crystal onto the seed crystal by the guide member 33 formed of a heat insulating material. Therefore, it is possible to produce the single crystal 27 having a high quality without a chance that the recessed surface is not formed at the radial direction end of the grown single crystal 27.

### [Third Reference Embodiment]

Subsequently, a third reference embodiment not according to the present invention is described; however, the parts having the same structure as those in the above-described passages are assigned with the same numeral so as to omit the description.

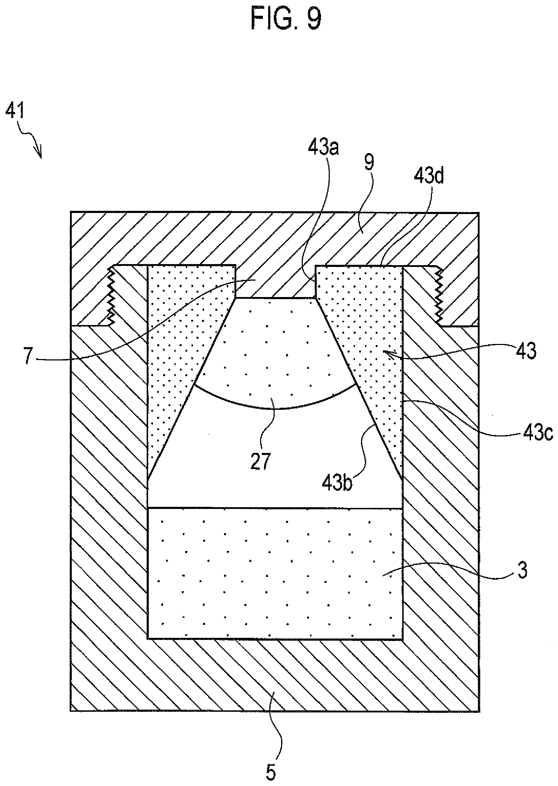

Fig. 9 is a cross-sectional view showing an apparatus 41 for manufacturing a silicon carbide single crystal according to a reference embodiment of the present invention.

A guide member 43 according to this embodiment is made of a heat insulating material, and is formed into an approximately cylindrical shape, as shown in Fig. 9. Specifically, the guide member 43 is formed in a cylindrical shape, the inner peripheral surface is formed such that the diameter expands from the outer peripheral side of the seed crystal supporting member 7 obliquely toward the other side (lower side, in this embodiment), which is the opposite side of one side, at which the sublimation material 3 is positioned, and the outer peripheral surface contacts with an inner wall surface 5a of the crucible main body 5. That is, the inner peripheral surface of the guide member 43 is formed by: an upper inner peripheral surface 43a that extends in the vertical direction; and a tapered lower inner peripheral surface 43b of which the diameter size expands obliquely downwardly from the lower end of the upper inner peripheral surface 43a. The outer peripheral surface 43c is formed on a cylindrical surface that extends in the vertical direction from the upper end all the way to the lower end. An upper surface 43d of the guide member 43 is joined, while abutting to the inner surface of the lid member 9.

The effect according to the embodiment will be described.
(1) The guide member 43 is formed in a cylindrical shape, inner peripheral surfaces 43a and 43b are formed such that the diameters expand obliquely from the outer peripheral side of the seed crystal supporting member 7 to the sublimation material 3, and an outer peripheral surface 43c contacts with an inner wall surface 5a of the crucible main body 5.

According also to this embodiment, it is possible to concentrate the flow of the heat H traveling from the sublimation material 3 to the seed crystal onto the seed crystal by the guide member 43 formed of a heat insulating material. Therefore, it is possible to produce the single crystal 27 having a high quality without a chance that the recessed surface is not formed at the radial direction end of the grown single crystal 27.

For example, in addition to the guide member 11, a heat insulating material may be arranged over the predetermined space S shown in Fig. 1 within the scope of claim 1.

### Example

Subsequently, the present invention will be further specifically described with reference to an example.

Firstly, as an apparatus of manufacturing a silicon carbide single crystal according to the example of the present invention, the manufacturing apparatus described by using Fig. 2 was used. Further, as a comparative example, the manufacturing apparatus 101 described by using Fig. 6 was used.

Each of the lid members and the crucible main bodies was made of graphite. For the heat insulating material according the example of the present invention, a molded heat insulating material made mainly of carbon felt was used. The heat insulating material has a heat conductivity lower than those of the lid member and the crucible main body. The heat conductivity at room temperature of the graphite that was the material of the lid member and the crucible main body was about 100 W/(m·K), and the heat conductivity at room temperature of the heat insulating material was about 0.2 W/(m·K). Thus, the heat insulating material is arranged in the manufacturing apparatus according to the example of the present invention, and the heat insulating material is not arranged in the conventional manufacturing apparatus, which is the comparative example.

When these manufacturing apparatuses were used to grow the silicon carbon single crystal, in the single crystal of the example of the present invention, it was possible to obtain a good single crystal in which a recessed surface was not formed at the radial direction end; however, in the single crystal of the comparative example, the recessed surface as shown in Fig. 6 was formed at the radial direction end. Thus, it was revealed that the manufacturing apparatus according to the example of the present invention could produce a good single crystal.

### [Other Embodiments]

In the embodiment, the upper portion of the crucible main body 5 is opened; however, the present invention is not limited thereto, and for example, a lower portion of the crucible main body 5 may be opened. In this case, the guide member extends in a cylindrical shape from the vicinity of the outer periphery of the seed crystal supporting member to the upper portion, i.e., the opposite side of the lower portion.

The technical range of the present invention is to be defined only by the inventive specific matter according to the adequate claims from the above description.

### INDUSTRIAL APPLICABILITY

As described above, the apparatus of manufacturing a silicon carbon single crystal according to the present invention can produce a high-quality single crystal while a recessed surface is not formed in a radial direction end of a grown single crystal, and therefore, the present invention is useful in the field of manufacturing a silicon carbon single crystal.

### REFERENCE NUMERAL

3···sublimation material, 5···crucible main body, 7···seed crystal supporting member, 9···lid member, 11,33,43···guide member, 21,23,25 ···heat insulating material

## Claims

1. An apparatus of manufacturing a silicon carbide single crystal, comprising:
a crucible main body (5) housing a sublimation material (3);
a lid member (9) including a seed crystal supporting member (7) of a cylindrical shape configured to fix a seed crystal at a position facing the sublimation material, the seed crystal supporting member protruding from the center in a radial direction of an inner surface of the lid member to the inner side of the crucible main body;
a guide member (11) of a cylindrical shape extending from the vicinity of an outer periphery of the seed crystal supporting member toward the sublimation material, such that it expands in a circular truncated cone shape downwardly from the vicinity of an outer peripheral side of the seed crystal supporting member, the lower end portion of the guide member being locked with an inner wall surface of the crucible main body so that the guide member is held; and
a heat insulating material (21, 23, 25) that has an inner peripheral surface being in contact with an outer peripheral surface of the seed crystal supporting member, the heat insulating material arranged at an outer peripheral side of the seed crystal supporting member, the heat insulating material attached to the inner surface of the lid member, and the heat insulating material having a disk shape and having a heat conductivity lower than a heat conductivity of the single crystal, wherein
when the sublimation material and the seed crystal are heated to grow the single crystal, a flow of heat traveling from the sublimation material to the seed crystal is concentrated onto the seed crystal by the heat insulating material, wherein a thickness of the heat insulating material is thinner than or the same as a height of the seed crystal supporting member.

## Patentansprüche

1. Vorrichtung zur Fertigung eines Siliciumcarbid-Einzelkristalls, umfassend:
einen Tiegelhauptkörper (5), der ein Sublimierungsmaterial (3) unterbringt;
ein Deckelelement (9), das ein Impfkristallträgerelement (7) einer zylindrischen Gestalt umfasst, das zum Fixieren eines Impfkristalls an einer Position konfiguriert ist, die dem Sublimierungsmaterial zugewandt ist, wobei das Impfkristallträgerelement aus der Mitte in einer radialen Richtung einer Innenfläche des Deckelelements zur Innenseite des Tiegelhauptkörpers hervorragt;
ein Führungselement (11) einer zylindrischen Gestalt, das sich aus der Umgebung einer äußeren Peripherie des Impfkristallträgerelements auf das Sublimierungsmaterial zu erstreckt, derart, dass es sich in einer kreisförmigen Kegelstumpfgestalt abwärts von der Umgebung einer äußeren peripheren Seite des Impfkristallträgerelements ausdehnt, wobei der untere Endteil des Führungselements mit einer inneren Wandoberfläche des Tiegelhauptkörpers so verriegelt ist, dass das Führungselement gehalten wird; und
ein Wärmeisoliermaterial (21, 23, 25), das eine innere periphere Oberfläche aufweist, die mit einer äußeren peripheren Oberfläche des Impfkristallträgerelements in Kontakt steht, wobei das Wärmeisoliermaterial an einer äußeren peripheren Seite des Impfkristallträgerelements angeordnet ist, das Wärmeisoliermaterial in die Innenfläche des Deckelelements angebracht ist und das Wärmeisoliermaterial eine Scheibengestalt aufweist und eine Wärmeleitfähigkeit besitzt, die geringer ist als die Wärmeleitfähigkeit des Einzelkristalls, wobei,
wenn das Sublimierungsmaterial und das Impfkristall zum Züchten des Einzelkristalls erwärmt werden, ein Wärmefluss, der von dem Sublimierungsmaterial zu dem Impfkristall strömt, auf dem Impfkristall durch das Wärmeisoliermaterial konzentriert wird, wobei eine Dicke des Wärmeisoliermaterials dünner als oder gleich wie eine Höhe des Impfkristallträgerelements ist.

## Revendications

1. Appareil de fabrication d'un monocristal de carbure de silicium, comprenant:
un corps principal de creuset (5) logeant un matériau de sublimation (3);
un élément formant couvercle (9) comprenant un élément de support de germe de cristal (7) d'une forme cylindrique configuré pour fixer un germe de cristal à une position faisant face au matériau de sublimation, l'élément de support de germe de cristal faisant saillie depuis le centre dans un sens radial d'une surface interne de l'élément formant couvercle vers le côté interne du corps principal de creuset;
un élément de guidage (11) d'une forme cylindrique s'étendant depuis la proximité d'une périphérie externe de l'élément de support de germe de cristal vers le matériau de sublimation, de sorte qu'il s'expanse en une forme de cône tronqué circulaire vers le bas depuis la proximité d'un côté périphérique externe de l'élément de support de germe de cristal, la partie d'extrémité inférieure de l'élément de guidage étant bloquée avec une surface de paroi interne du corps principal de creuset de sorte que l'élément de guidage est maintenu; et
un matériau thermiquement isolant (21, 23, 25) qui possède une surface périphérique interne qui se trouve en contact avec une surface périphérique externe de l'élément de support de germe de cristal, le matériau thermiquement isolant disposé au niveau d'un côté périphérique externe de l'élément de support de germe de cristal, le matériau thermiquement isolant fixé à la surface interne de l'élément formant couvercle, et le matériau thermiquement isolant ayant une forme de disque et ayant une conductivité thermique inférieure à une conductivité thermique du monocristal, où
lorsque le matériau de sublimation et le germe de cristal sont chauffés pour faire croître le monocristal, un flux de chaleur se déplaçant depuis le matériau de sublimation vers le germe de cristal est concentré sur le germe de cristal par le matériau thermiquement isolant, où une épaisseur du matériau thermiquement isolant est plus fine que, ou identique à, une hauteur de l'élément de support de germe de cristal.
